# EUROPEAN PATENT SPECIFICATION

(11) **EP 0 527 668 B1**
(45) Date of publication and mention of the grant of the patent: **25.09.1996**
(21) Application number: 92402183.5
(22) Date of filing: 29.07.1992
(51) Int. Cl.: H01L 39/24, C23C 14/28, C23C 14/34

(54) **Method for preparing a superconducting thin film of compound oxide**
Verfahren zur Herstellung einer dünnen Schicht einer supraleitenden Oxid-Verbindung
Procédé pour la fabrication d'une couche mince d'un supraconducteur en oxyde composé

(30) Priority: 29.07.1991 JP 211505/91
(43) Date of publication of application: 17.02.1993
(73) Proprietor: Sumitomo Electric Industries, Ltd., Osaka 541 (JP)
(72) Inventor: Nagaishi, Tatsuoki, c/o Itami Works of Sumitomo, Itami-shi, Hyogo (JP); Nakanishi, Hidenori, c/o Itami Works of Sumitomo, Itami-shi, Hyogo (JP); Tanaka, Saburo, c/o Itami Works of Sumitomo, Itami-shi, Hyogo (JP); Itozaki, Hideo, c/o Itami Works of Sumitomo, Itami-shi, Hyogo (JP)
(74) Representative: Polus, Camille

(56) References cited:
- EP-A- 0 341 520
- EP-A- 0 396 099
- GB-A- 2 189 509
- US-A- 4 834 856
- JOURNAL OF APPLIED PHYSICS. vol. 68, no. 12, 15 December 1990, NEW YORK US, pages 6331-6335, H. IZUMI ET AL: 'Superconductivity and crystallinity of Ba2Y1Cu3O7-d thin films prepared by pulsed laser deposition with substrate bias voltage'
- JAPANESE JOURNAL OF APPLIED PHYSICS, PART2, LETTERS vol. 29, no. 10, October 1990, TOKYO JP, pages L1813-L1815; T. NABATAME ET AL: 'Properties of Tl2Ba2Ca2Cu3Ox thin films with a critical temperature of 122K prepared by excimer laser ablation'
- PHYSICA C SUPERCONDUCTIVITY vol. 167, no. 5/6, 15 May 1990, AMSTERDAM NL, pages 509-514; S. BECKER ET AL: 'Change in stoichiometry by laser-induced plasma deposition of high-Tc superconducting thin films'
- PHYSICA C SUPERCONDUCTIVITY vol. 168, no. 5/6, 1 July 1990, AMSTERDAM NL, pages 599-604; L. GANAPATHI ET AL: 'In situ processing of LaBa2Cu3O7-d thin films by laser ablation method'
- PATENT ABSTRACTS OF JAPAN vol. 015, no. 421 (C-0878) 25 October 1991 & JP-A-3 174 306

## Description

### Background of the Invention

### Field of the invention

The present invention relates to an improvement in a method for preparing a superconducting thin film of compound oxide having a large area by laser evaporation technique.

### Description of the related art

Superconductivity have been thought, for a long time, to be a phenomenon observable at ultra-low temperatures realized with liquid helium as a cryogen. However, the possibility of an existence of a new type of superconducting material was revealed by Bednorz and Müller, who discovered (La, Sr)₂CuO₄ which exhibit the superconductivity at 30 K in 1986. C. W. Chu et al. discovered, in the United States of America, another superconducting material of YBa₂Cu₃O_{7-δ} having the critical temperature of about 90 K in 1987. Maeda et al discovered so-called bismuth type superconducting material. And hence, the possibility of an actual utilization of high-Tc superconductors have burst onto the scene because the superconductivity can be realized with cheap cryogen of liquid nitrogen.

The above-mentioned new type superconducting materials were obtained in a form of sintered mass prepared by powder metallurgy. But now, they can be prepared in a thin film form of very high quality.

Laser evaporation technique is one of the most promising techniques because superconducting thin films which exhibit improved superconducting properties can be prepared by the laser evaporation technique with no after-treatment such as annealing of thin films deposited on a substrate.

In the laser evaporation method, a target is irradiated with a laser beam to create a plume which is then deposited on a substrate. Therefore, an area of a thin film prepared by the laser evaporation method is limited to the dimension or an effective cross-sectional area of the plume which is limited by a diameter of a laser beam. However, since available laser is limited, the diameter of laser beam is limited and hence the dimension or area of thin film prepared is limited.

In J. Appl. Phys. 68 (12), 1990, pages 6331-6335, the preparation of superconducting oxide films by laser irradiation of a cylindrical target of sintered Ba₂YCu₃O₇₋ₓ is described. A plume of particles which diverges is created. However, the particles diverge in only two opposite directions and the area of the film prepared is therefore limited in the other directions.

GB-2-189 509 discloses a laser evaporation method using a cylindrical ceramic target comprising a tip onto which a laser beam impinges and being rotated about its axis in order to insure that the evaporation of the ceramic material is uniform.

Therefore, an object of the present invention is to provide a novel process for preparing a superconducting thin film of oxide possessing a large area.

### Summary of the Invention

The present invention provides a method of preparing a superconducting thin film of compound oxide by laser evaporation technique, characterized in that the surface of a target onto which a laser beam impinges is spherically or conically curved in such a manner that a created plume diverges radially.

In the known laser evaporation method, the plume created from the target by a laser beam which impinges onto the target is emitted perpendicularly to a surface of the target.

According to the present invention, the target has a convex surface so that the plume created from the target by a laser beam which impinges onto the target diverges radially. Therefore, the diameter of the plume on the surface of a substrate becomes very large and hence a thin film of compound oxide of large area is obtained.

The plume can be diverged by using a target having a spherically or conically curved surface.

The laser evaporation technique itself is well-known and usual operational condition can be used in the present invention. Followings are typical operational conditions:

| | |
|---|---|
| Substrate temperature | 600 to 750 °C |
| Gas pressure in chamber | 13.33 N.m⁻²(100mTorr) to 133.3 N.m⁻²(1,000mTorr) |
| Distance between the target and the substrate | 40 to 100 mm |
| Laser density | 1.0 to 3.0 J/cm² |
| Deposition rate: | 1 to 100 nm/min (10 to 1,000 Å/min) |

Any laser can be used but an excimer laser is usually used.

The substrate is preferably a single crystal substrate of oxide such as MgO, SrTiO₃, LaAlO₃, LaGaO₃ and yttrium stabilized zirconia (YSZ).

The process according to the present invention can be used for preparing thin films of any known high-Tc superconductors such as La-Sr(Ba)-Cu-O, Y-Ba-Cu-O, Bi-Sr-Ca-Cu-O and Tl-Ba-Ca-Cu-O.

The process according to the present invention permits to prepare a superconducting thin film of compound oxide possessing a large surface area.

### Brief Description of the Drawing

Fig.1 illustrates a structure of a film forming apparatus which can be used in the process according to the present invention.

Fig.2 illustrates targets used in the apparatus of Fig. 1 in cross section.

Fig.3 are contour maps of film thickness prepared in Example.

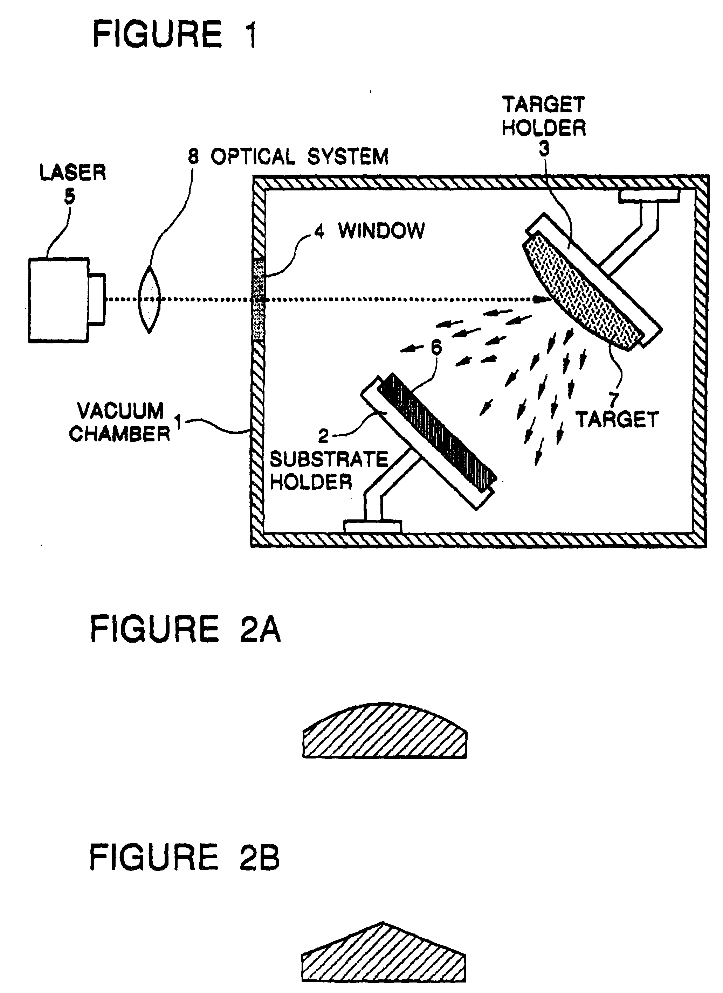

The film forming apparatus shown in Fig. 1 comprises a vacuum chamber 1 in which a substrate holder 2 and a target holder 3 are positioned and a laser 5 which emits a laser beam to a target through a transparent window 4 secured to the vacuum chamber 1.

The substrate holder 2 and the target holder 3 are constructed in such a manner that each of substrate 6 and target 7 can be positioned at desired level, orientation and angle. The laser beam emitted from the laser 5 is converged by an optical system 8.

Fig. 2 illustrates cross-section of targets 7 which can be used in the apparatus shown in Fig. 1.

The target 7 has a convex surface such as a spherical surface as shown in Fig. 2(a) or a conical surface shown in Fig. 2(b) each illustrated in a cross-section.

According to the present invention, a plume created by a laser beam which impinges onto the target 7 diverge radially from the target 7 and deposit on the substrate 6 at a larger area.

Now, the present invention will be described with reference to Example, but the scope of the invention should not be limited to the

### Description of the Preferred Embodiment

A superconducting thin film of Y-type compound oxide by using the apparatus shown in Fig. 1.

A thin film was deposited on a (100) plane of MgO single crystal substrate by laser evaporation method. As a target, a sintered body of compound oxide represented by a composition of YBa₂Cu₃O_{y} was used.

Sample 1 was prepared by using a target (diameter of 15 mm, height of 5 mm) having a spherical surface (curvature of 10 mm).

Sample 2 was prepared by using a conical target having a diameter of 15 mm and a height of 5 mm.

For comparison, sample 3 was prepared by using a pyramid target having a square base of 15 mm side and a height of 5 mm.

Also for comparison, sample 4 is prepared in the same apparatus as above but using a flat target.
Operational conditions used are summarized in Table 1.

**Table 1**

| | |
|---|---|
| Substrate temperature | 700°C |
| Gas pressure | 53.32N.m⁻² (400mTorr) |
| Laser energy density | 1.5 to 2.0 J/cm² |
| Film thickness | 200 nm (2,000 Å) |
| Distance between | |
| substrate and target | 50 mm |

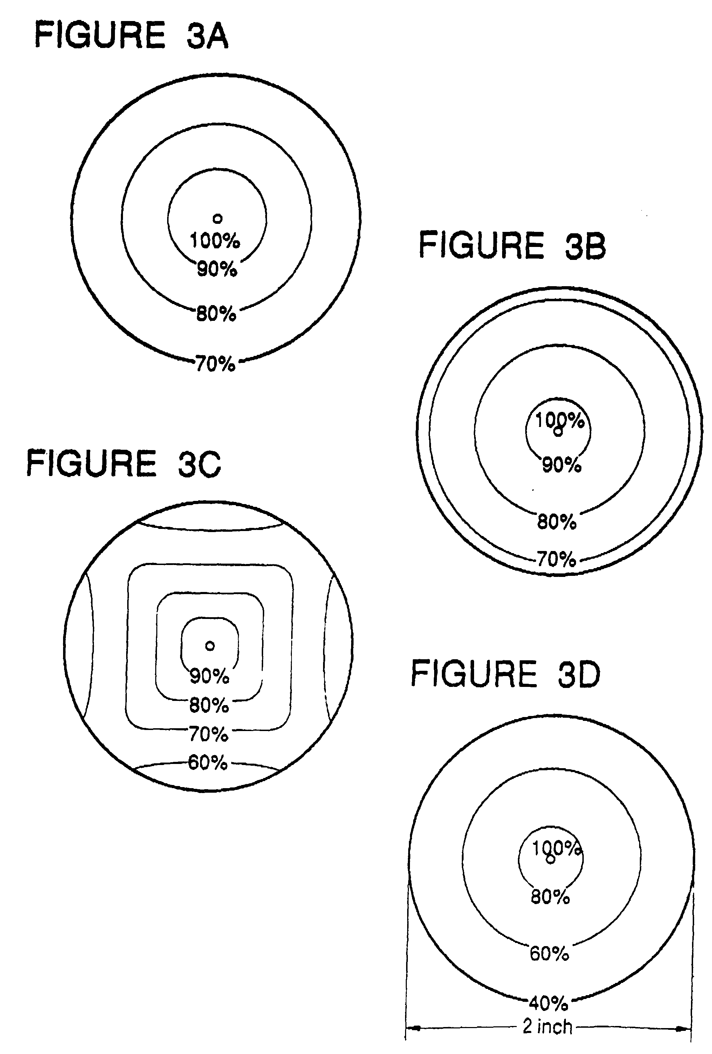

Fig. 3 illustrates contour maps of film thickness prepared. Relation between samples and the contour maps is shown in Table 2.

**Table 2**

| | |
|---|---|
| Sample 1 | Fig. 3 (a) |
| Sample 2 | Fig. 3 (b) |
| Sample 3 | Fig. 3 (c) |
| Sample 4 | Fig. 3 (d) |

## Claims

1. Method of preparing a superconducting thin film of compound oxide on a substrate (6) disposed in a vacuum chamber (1) by laser evaporation technique, characterized in that the surface of a target (7) onto which a laser beam impinges is spherically or conically curved in such a manner that a created plume diverges radially.

2. The method set forth in claim 1 wherein the substrate is heated at a temperature between 600 and 750°C.

3. The method set forth in claim 1 to 2 wherein the gas pressure in chamber is adjusted between 13.33 N m⁻² (100 m Torr) and 133.3 N m⁻² (1,000 m Torr).

4. The method set forth in any one of claim 1 to 3 wherein the distance between the target and the substrate is adjusted between 40 and 100 mm.

5. The method set forth in any one of claim 1 to 4 wherein a laser beam has a energy density of between 1.0 and 3.0J/cm².

6. The method set forth in any one of claim 1 to 5 wherein the deposition rate is adjusted between 1 and 100 nm/min (10 and 1,000 Å/min).

7. The method set forth in any one of claim 1 to 6 wherein the compound oxide is a high-Tc superconductor.

8. The method set forth in claim 7 wherein the compound oxide is selected from a group consisting of La-Sr(Ba)-Cu-O,Y-Ba-Cu-O,Bi-Sr-Ca-Cu-O and Tl-Ba-Ca-Cu-O.

## Patentansprüche

1. Verfahren zur Herstellung einer supraleitenden Dünnschicht aus Verbundoxid auf einem in einer Vakuumkanmer (1) angeordneten Substrat (6) mittels der Laserverdampfungstechnik, dadurch gekennzeichnet, daß die Oberfläche eines Targets (7), auf die ein Laserstrahl auftrifft, sphärisch oder konisch derart gewölbt ist, daß ein erzeugter Teilchenschauer sich radial ausbreitet.

2. Verfahren nach Anspruch 1, bei dem das Substrat auf eine Temperatur zwischen 600 und 750°C aufgeheizt wird.

3. Verfahren nach Ansprüchen 1 oder 2, bei dem der Gasdruck in der Kammer auf einen Wert zwischen 13,33 N m⁻² (100 m Torr) und 133,3 N m⁻² (1000 m Torr) eingestellt wird.

4. Verfahren nach einem der Ansprüche 1 bis 3, bei dem der Abstand zwischen dem Target und dem Substrat auf einen Wert zwischen 40 und 100 mm eingestellt wird.

5. Verfahren nach einem der Ansprüche 1 bis 4, bei dem der Laserstrahl eine Energiedichte zwischen 1,0 und 3,0J/cm² aufweist.

6. Verfahren nach einem der Ansprüche 1 bis 5, bei dem die Abscheiderate auf einen Wert zwischen 1 und 100 nm/min (10 bis 1000 Å/min) eingestellt wird.

7. Verfahren nach einem der Ansprüche 1 bis 6, bei dem als Verbundoxid ein Supraleiter mit hoher Tc verwendet wird.

8. Verfahren nach Anspruch 7, bei dem das Verbundoxid ausgewählt wird aus einer Gruppe, bestehend aus La-Sr(Ba)-Cu-O, Y-Ba-Cu-O, Bi-Sr-Ca-Cu-O und Tl-Ba-Ca-Cu-O.

## Revendications

1. Procédé pour préparer un film mince supraconducteur d'un oxyde sur un substrat (6) disposé dans une chambre à vide (1) au moyen d'une technique de dépôt par évaporation par laser, caractérisé en ce que la surface d'une cible (7), que rencontre un faisceau laser, est incurvée avec une forme sphérique ou conique de telle sorte qu'un flux projeté de matière, produit diverge radialement.

2. Procédé selon la revendication 1, selon lequel on chauffe le substrat à une température entre 600 et 750°C.

3. Procédé selon la revendication 1 ou 2, selon lequel la pression du gaz dans la chambre est réglée entre 13,33 Nm⁻² (100 mtorrs) et 133,3 Nm⁻² (1000 mtorrs).

4. Procédé selon l'une quelconque des revendications 1 à 3, selon lequel la distance entre la cible et le substrat est réglée entre 40 et 100 mm.

5. Procédé selon l'une quelconque des revendications 1 à 4, selon lequel un faisceau laser possède une densité d'énergie comprise entre 1,0 et 3,0 J/cm².

6. Procédé selon l'une quelconque des revendications 1 à 5, selon lequel la vitesse de dépôt est réglée entre 1 et 100 nm/mn (10 et 1000 Å/mn).

7. Procédé selon l'une quelconque des revendications 1 à 6, selon lequel l'oxyde est un supraconducteur possédant une température Tc élevée.

8. Procédé selon la revendication 7, selon lequel l'oxyde mixte est choisi dans un groupe comprenant La-Sr(BA)-Cu-O,Y-Ba-Cu-O,Bi-Sr-Ca-Cu-O et Tl-Ba-Ca-Cu-O.
